Europäisches Patentamt

European Patent Office

Office européen des brevets

(11) Veröffentlichungsnummer: **0 254 099**

**A1**

## (12) EUROPÄISCHE PATENTANMELDUNG

(21) Anmeldenummer: 87109552.7

(22) Anmeldetag: 02.07.87

(51) Int. Cl.4: **H05K 13/00 , B65D 73/02**

(30) Priorität: 17.07.86 DE 3624185

(43) Veröffentlichungstag der Anmeldung:
27.01.88 Patentblatt 88/04

(84) Benannte Vertragsstaaten:
DE FR GB

(71) Anmelder: **Siemens Aktiengesellschaft Berlin und München**
**Wittelsbacherplatz 2**
**D-8000 München 2(DE)**

(72) Erfinder: **Hein, Hans**
**Pfälzer-Wald-Strasse 51**
**D-8000 München 90(DE)**

(54) **Gurt zum maschinengerechten Zuführen von Stückgütern, insbesondere von elektrischen bauelementen und Bauelementegruppen in Bestückungsautomaten für Leiterplatten.**

(57) Ein Gurt 1 aus einem Trägerband, das mit Transportlöchern 7 und regelmäßig angeordneten Wannen 3 oder Ausstanzungen für die Aufnahme von Stückgütern versehen ist, hat in gleichbleibenden Abständen stückgutfreie Faltbereiche 2, in denen der Gurt um jeweils 180° faltbar und dadurch mehrlagig zu einer Ammo-Verpackung stapelbar ist. Die Faltbereiche 2 sind mit Mitteln versehen, die ein leichteres Falten des Gurtes 1 und damit ein spannungsfreies Transportieren der Stückgüter erlauben.

# FIG 9

## Gurt zum maschinengerechten Zuführen von Stückgütern, insbesondere von elektrischen Bauelementen und Bauelementegruppen in Bestückungsautomaten für Leiterplatten

Die Erfindung betrifft einen Gurt zum maschinengerechten Zuführen von Stückgütern, insbesondere von elektrischen Bauelementen und Bauelementegruppen in Bestückungsautomaten für Leiterplatten mit einem Trägerband, das mit Transportlöchern und regelmäßig angeordneten Wannen oder Ausstanzungen versehen ist, die im bepackten Zustand mit einer lösbaren Deckfolie verschlossen sind.

Die Zeitschrift "Elektronik Nr. 21", Ausgabe 23.10.1981, gibt auf den Seiten 104 bis 121 einen Überblick über die heute üblichen Systeme auf dem Gebiet der Bestückung von elektronischen Bauelementen und vergleicht die Gurtzuführung mit der Einzelbestückung bzw. der Magazinzuführung. Bezüglich Handhabung, Platzbedarf und Kosten für die notwendige Verpackung bieten demzufolge die Gurtsysteme gegenüber der Magazin-und der Einzelzuführung deutliche Vorteile.

Weltweit ist man dabei bestrebt, die Vielzahl der heute üblichen Gurtsysteme zu standardisieren. So ist beispielsweise im Normungsvorhaben der "International Electrotechnical Commission" (IEC-Standard Publikation 286-3, 1. Ausgabe 1986) der Abstand und die Größe der Transportlöcher ebenso festgelegt wie die Dicke und die Breite des Gurtbandes. Besonders in den Bearbeitungsbetrieben der Elektronikindustrie sind die Gurtsysteme für die Zuführung von elektronischen Bauelementen in Bestückungsautomaten bereits weit verbreitet. Hier werden bedrahtete Bauelemente an ihren Drahtenden mittels eines Klebebandes auf Gurten fixiert und für den Versand nach verschiedenen Methoden verpackt.

Drei Verpackungsformen für Gurte haben sich bislang praktisch bewährt und durchgesetzt. Bei der sog. Trommelververpackung wird der bestückte Gurt zusammen mit einem Beilaufband als Zwischenlage zum Schutz gegen ein Verhaken der Bauelemente, auf die Achse einer Trommel gespult. Beim Ablauf des Gurtes dreht sich die Trommel selbst auf einer Welle in einem Magazinschacht.

Ähnlich der Trommelverpackung wird bei der sog. Kassettenverpackung der Gurt auf eine Hülse aufgewickelt, die in einem geschlossenen Karton zentriert ist.

Im Gegensatz zu diesen beiden Rollenverpackungen steht die Lagenverpackung oder Ammo-Verpackung. Der Gurt ist hier nicht aufgerollt, sondern zickzack-förmig gefalzt und platzsparend mehrlagig in einem Karton untergebracht.

Nur die Ammo-Verpackung bietet zudem die Alternativen, die Bauelemente bei Bedarf auch um 180° gedreht dem Bestückungsautomaten zuzuführen. In diesem Falle wird lediglich die gegenüberliegende Kartonseite geöffnet und der Gurt vom Gurtende aus entfaltet.

In letzter Zeit wird die automatische Bestückung von Bauelementen ohne Drahtanschlüsse, in sogenannter SMD-Technik (oberflächenmontierte Vorrichtungen) bevorzugt. Da bei diesen unbedrahteten Bauelementen eine Fixierung über die Anschlußdrähte nicht möglich ist, müssen die Gurte selbst mit entsprechenden Ausstanzungen oder Wannen versehen werden. Während kleinere Bauteile bequem in den Ausstanzungen dicker Gurtbänder Platz finden, können größere, drahtlose Bauteile nur in sog. Blistergurten verpackt werden.

Ein Blistergurt besteht dabei aus einem Kunststoffband, in das dem Bauteil angepaßte Wannen, beispielsweise nach einem Tiefziehverfahren, eingezogen sind. Sowohl die Wannen als auch die Ausstanzungen werden nach dem Einlegen der Bauelemente mit abziehbaren Deckfolien verschlossen.

Zum Transport dieser Blistergurte sind nur Rollenverpackungen gebräuchlich. Die platzsparende und kostengünstige Lagenverpackung ist hier nicht möglich, da sowohl bei dicken Gurtbändern als auch bei Blistergurten eine scharfe Faltung, wie sie bei der Ammo-Verpackung notwendig ist, nicht angewendet werden kann.

Bei großflächigem Stückgut führen aber auch die beiden Rollenverpackungen zu Problemen. Beim Aufrollen derartig bestückter Gurte muß nämlich ein relativ großer minimaler Wickel-Durchmesser eingehalten werden, der zu einem überdurchschnittlich großen Raumbedarf führt. Darüberhinaus knickt der Gurt beim Aufrollen systembedingt zwischen den Bauelementen ein, wobei die Gefahr besteht, daß die Wannen mit den Bauelementen verformt werden bzw. die Deckfolie an exponierten Stellen gestaucht und abgelöst wird.

Der Erfindung liegt die Aufgabe zugrunde, einen Gurt zum Zuführen von Stückgut in Verarbeitungsautomaten so zu gestalten, daß der bestückte Gurt wirtschaftlich hergestellt, sicher transpotiert und raumsparend gelagert werden kann.

Diese Aufgabe wird erfindungsgemäß dadurch gelöst. daß das Trägerband in gleichbleibenden Abständen stückgutfreie Faltbereiche aufweist und daß die Faltbereiche mit Mitteln versehen sind, durch welche der Gurt spannungsfrei um jeweils 180° faltbar und mehrlagig zu einer Ammo-Verpackung stabelbar ist.

Durch diese erfindungsgemäße Ausgestaltung der Gurte ist es möglich, die bei bedrahteten Bauelementen bewährte Methode der raumsparenden Lagenverpackung auf beliebige und insbesondere für den Einsatz in der SMD-Technik bestimmte Stückgutformen anzuwenden.

Auf die Wannen bzw. die darin befindlichen Stückgüter wirken dabei keinerlei Spannungen. Stauchungen bzw. Dehnungen der Deckfolie erfolgen ausschließlich innerhalb des stückgutfreien Faltbereiches. Damit ist eine größtmögliche Sicherheit gegen Beschädigungen der Stückgüter gewährleistet. Die Lagenverpackung führt gegenüber der Rollenverpackung grundsätzlich zu einer besseren Raumausnutzung und einer Kostenminderung, zumal auf die Rolle bzw. Hülse verzichtet werden kann.

Das regelmäßige Fehlen der Stückgüter in den Faltbereichen wird von den Erkennungseinrichtungen der Verarbeitungsautomaten registriert und durch einfaches Weitertransportieren des Gurtes um eine Wannen-bzw. Ausstanzlänge ausgeglichen.

Besonders vorteilhafte Ausgestaltungen der Faltbereiche ergeben sich aus den Unteransprüchen.

So können beispielsweise bei der Fertigung dicker Gurtbänder in einem einzigen Arbeitsschritt sowohl die Ausstanzungen für die Stückgüter als auch entsprechende Lochungen im Faltbereich hergestellt werden. Blistergurte können gleichzeitig mit dem Tiefziehen der Wannen mit Sicken oder Wellungen in den Faltbereichen ausgestaltet werden.

Besonders flexibel läßt sich der Faltbereich gestalten, wenn das Trägerband in diesem Bereich teilweise entfernt und beispielsweise durch die Deckfolie selbst oder ein flexibles Zwischenstück ersetzt ist.

Weitere Einzelheiten und vorteilhafte Ausgestaltungen des Erfindungsgegenstandes sind anhand der Zeichnung näher erläutert. Es zeigt:

Fig. 1,2 in Draufsicht bzw. im Schnitt einen Abschnitt eines ungefalteten, beladenen Gurtes nach der Erfindung,

Fig. 3-8 alternative Ausgestaltungen von Faltbereichen und

Fig. 9 eine Seitenansicht eines gefalteten, mit Stückgut bepackten Gurtes in der raumsparenden Ammo-Verpackung.

In allen Figuren sind gleiche Teile mit den gleichen Bezugszeichen versehen.

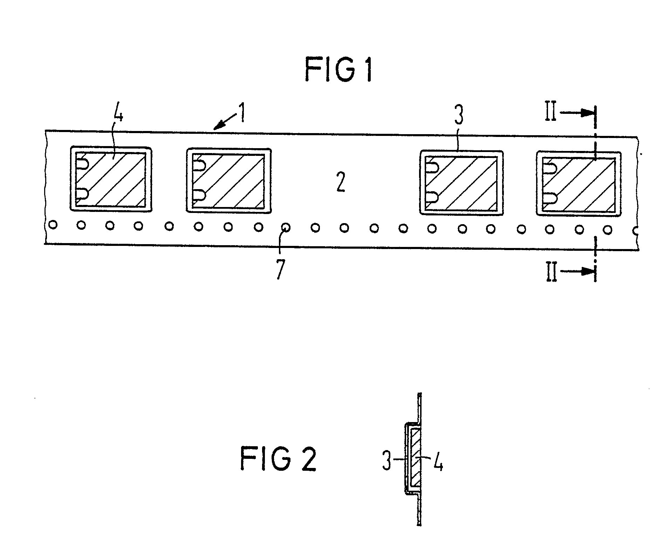

Der in Fig. 1 dargestellte Gurtabschnitt 1 zeigt eine erfindungsgemäße Anordnung eines Faltbereiches 2 in einer Sequenz tiefgezogener Wannen 3. Die Länge des Faltbeteiches 2 entspricht dabei exakt der Länge einer Wanne 3 samt den Abständen zur jeweiligen Nachbar-Wanne. In den Wannen 3 liegen SMD-Bauelemente 4. Eine Deckfolie, die über die Wannen geklebt wird, um ein Herausfallen der Bauelemente 4 zu verhindern, ist noch nicht aufgeschweißt. Am unteren Gurtrand sind Transportlöcher 7 für die maschinelle Gurtförderung ausgestanzt.

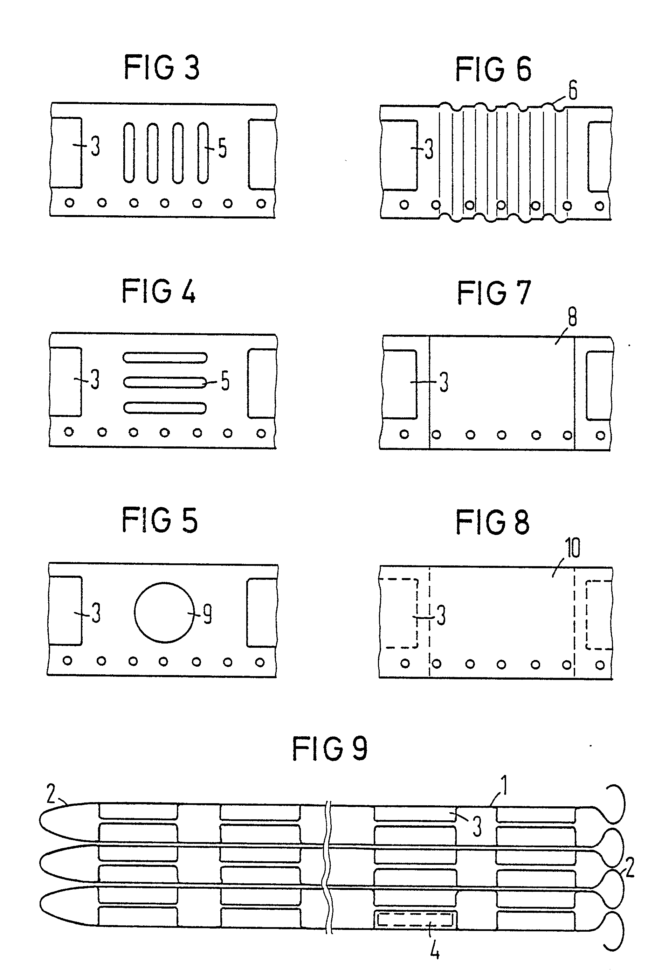

In Fig. 2, die einen Schnitt gemäß der Linie 2-2 in Fig. 1 zeigt, ist eine tiefgezogene Wanne 3 mit einem eingelegten Bauelement 4 dargestellt.

Die Figuren 3 - 8 zeigen spezielle Ausgestaltungen des Faltbereiches 2. In Fig. 3 sind mehrere parallele Lochungen 5 im Trägerband quer zur Förderrichtung vorgenommen. In Fig. 4 verlaufen diese Lochungen 5 in Förderrichtung, während in Fig. 5 hierfür ein einzelnes Rundloch 9 vorgesehen ist. Fig. 6 zeigt eine Ausführung mit Querwellungen 6 zwischen den Transportlöchern 7, während in Fig. 7 innerhalb des Faltbereiches 2 ein Stück des Trägerbandes entfernt und durch ein flexibles Zwischenstück 8 ersetzt wurde. In Fig. 8 ist ebenso wie in Fig. 7 ein Stück des Trägerbandes entfernt. Die Funktion des flexiblen Zwischenstücks 8 wird in diesem Fall von der Deckfolie 10 übernommen, die sich über die gesamte Gurtbreite erstreckt und mit Transportlöchern 7 versehen ist.

Fig. 9 zeigt schließlich einen Auschnitt aus einer mehrlagigen Ammo-Verpackung. In jedem Faltbereich 2 ist der Gurtabschnitt 1 um 180° gefaltet. Auf diese Weise entstehen gerade Gurtabschnitte in denen auf die Wannen 3 bzw. auf die darin enthaltenen Bauelemente 4 keine Faltspanungen wirken. Der auf diese Weise gefaltete Gurtaschnitt läßt sich raumsparend in einen Karton verpacken und ohne zusätzliche Transporthilfen wie Hülsen oder Achsen vom Verarbeitungsautomaten entfalten.

Bezugszeichenliste

1 Gurtabschnitt
2 Faltbereich
3 Wanne
4 Bauelemente
5 Lochung
6 Querwellungen
7 Transportlöcher
8 Zwischenstück
9 Rundloch
10 Deckfolie

**Ansprüche**

1. Gurt, geeignet zum maschinengerechten Zuführen von Stückgütern, insbesondere von elektrischen Bauelementen und Bauelementgruppen in Bestückungsautomaten für Leiterplatten, mit einem Trägerband, das mit Transportlöchern und regelmäßig angeordneten Wannen oder Ausstanzungen für die Aufnahme der Stückgüter versehen ist,

**dadurch gekennzeichnet**, daß das Trägerband in gleichbleibenden Abständen stückgutfreie Faltbereiche aufweist und daß die Faltbereiche mit Mitteln versehen sind, durch welche der Gurt spannungsfrei um jeweils 180° faltbar und dadurch mehrlagig zu einer Ammo-Verpackung stapelbar ist.

2. Gurt nach Anspruch 1
**dadurch gekennzeichnet,** daß die Länge des Faltbereiches mit der Länge einer Wanne bzw einer Ausstanzung übereinstimmt.

3. Gurt nach Anspruch 1,
**dadurch gekennzeichnet**, daß zum spannungsfreien Falten des Gurtes im Faltbereich Lochungen ausgebildet sind.

4. Gurt nach Anspruch 1 und 3,
**dadurch gekennzeichnet**, daß die Lochungen im Faltbereich in Quer-und/oder in Längsrichtung zum Gurt verlaufen.

5. Gurt nach Anspruch 1,
**dadurch gekennzeichnet**, daß im Faltbereich quer zur Gurtlängsrichtung verlaufende Sicken und/oder Wellungen vorgesehen sind.

6. Gurt nach Anspruch 1 und mindestesn einem der weiteren Ansprüche 2 bis 5,
**dadurch gekennzeichnet**, daß die Dicke des Trägerbandes im Faltbereich geringer ist.

7. Gurt nach Anspruch 1 und einem der weiteren Ansprüche 2 bis 6,
**dadurch gekennzeichnet**, daß das Trägerband im Faltbereich durch ein flexibles Zwischenstück ersetzt ist.

8. Gurt nach Anspruch 1 und 7.
**dadurch gekennzeichnet**, daß das flexible Zwischenstück mindestens zum Teil aus einer, über die Wannen bzw. Ausstanzungen geklebten Deckfolie besteht.

## FIG 1

## FIG 2

FIG 3

FIG 6

FIG 4

FIG 7

FIG 5

FIG 8

FIG 9

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| Y | EP-A-0 050 865 (SILLNER) <br> * Seite 4, Zeile 26 - Seite 5, Zeile 2; Anspruch; Figur 6 * <br><br> --- | 1,2,5 | H 05 K 13/00 <br> B 65 D 73/02 |
| Y | FR-A-2 445 273 (MURATA) <br> * Seite 9, Zeilen 28-38; Seite 10, Zeilen 1-16; Seite 11, Zeilen 19-23 * <br><br> --- | 1,2,5 | |
| A | FR-A- 784 958 (SIGISMONDI) <br> * Seite 1, Zeilen 48-52; Seite 2, Zeilen 11-17; Figuren 2-5 * <br><br> --- | 1,3,4 | |
| A | FR-A-2 149 868 (NAUTILOID) <br> * Seite 7, Zeilen 6-8; Figuren 7,8 * <br><br> ----- | 1 | |

RECHERCHIERTE SACHGEBIETE (Int. Cl.4)

H 01 L 21/00
H 05 K 13/00
B 65 D 73/00

Der vorliegende Recherchenbericht wurde für alle Patentansprüche erstellt.

| Recherchenort | Abschlußdatum der Recherche | Prüfer |
|---|---|---|
| DEN HAAG | 22-10-1987 | TIELEMANS H.L.A. |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur
T : der Erfindung zugrunde liegende Theorien oder Grundsätze

E : älteres Patentdokument, das jedoch erst am oder nach dem Anmeldedatum veröffentlicht worden ist
D : in der Anmeldung angeführtes Dokument
L : aus andern Gründen angeführtes Dokument

& : Mitglied der gleichen Patentfamilie, übereinstimmendes Dokument

EPA Form 1503 03 82